# EUROPEAN PATENT APPLICATION

(11) **EP 3 926 663 A1**
(43) Date of publication of application: **22.12.2021**
(21) Application number: 20756673.8
(22) Date of filing: 13.02.2020
(51) Int. Cl.: H01L 21/306

(54) **SEMICONDUCTOR WAFER TREATMENT LIQUID CONTAINING HYPOCHLORITE IONS AND PH BUFFER**

(30) Priority: 13.02.2019 JP 2019024016
(71) Applicant: Tokuyama Corporation, Shunan-shi, Yamaguchi 745-8648 (JP)
(72) Inventor: SHIMODA, Takafumi, Shunan-shi, Yamaguchi 745-8648 (JP); KIKKAWA, Yuki, Shunan-shi, Yamaguchi 745-8648 (JP); NEGISHI, Takayuki, Shunan-shi, Yamaguchi 745-8648 (JP); TONO, Seiji, Shunan-shi, Yamaguchi 745-8648 (JP); SATO, Tomoaki, Shunan-shi, Yamaguchi 745-8648 (JP)
(74) Representative: Jones, Nicholas Andrew
(86) International application number: PCT/JP2020/005655
(87) International publication number: WO 2020/166676

(57) **Abstract**

The present invention provides a treatment liquid for treating a semiconductor wafer in a semiconductor formation process, the treatment liquid including: (A) hypochlorite ion; (B) a pH buffer; and (C) a tetraalkylammonium ion represented by the following formula (1): 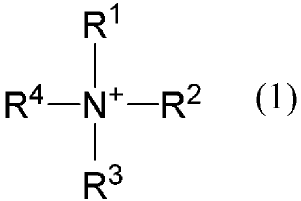 (wherein each of R¹, R², R³ and R⁴ is independently an alkyl group having carbon number from 1 to 20).

## Description

### TECHNICAL FIELD

The present invention relates to a novel treatment liquid for etching ruthenium present on a semiconductor wafer, which is used in the production process of a semiconductor element.

### BACKGROUND ART

In recent years, the miniaturization of design rules for semiconductor elements are in progress, and there is a tendency for an increase in wiring resistance. As a result of the increased wiring resistance, high-speed operations of semiconductor elements tend to be significantly hindered, and countermeasures therefor have been needed. Therefore, wiring materials in which electromigration resistance is high and the wiring resistance value is reduced as compared to those of conventional wiring materials are needed.

Ruthenium is drawing attention as a wiring material for use in a semiconductor element with a design rule of 10 nm or less, in particular, because ruthenium has a higher electromigration resistance, and is capable of reducing the wiring resistance value, as compared to aluminum and copper which are conventional wiring materials. In addition, since ruthenium is capable of preventing the electromigration even in cases where copper is used as a wiring material, the use of ruthenium has been investigated not only as a wiring material, but also as a barrier metal for a copper wiring.

Even in cases where ruthenium is selected as a wiring material in the step of forming the wiring of a semiconductor element, the wiring is formed by dry or wet etching, in the same manner as in the case of using a conventional wiring material. However, since it is difficult to etch ruthenium by dry etching with an etching gas or etching by CMP polishing, and to remove ruthenium, a more precise etching is desired. Specifically, wet etching is drawing attention.

In cases where ruthenium is used as a wiring material or a barrier metal, a precise microfabrication of ruthenium by wet etching is required. However, if the etching amount of ruthenium is not adequately controlled, there are cases where other wiring materials may be exposed due to wet etching. If a multilayer wiring is formed with the wiring materials other than ruthenium being left exposed, it is known that the current leaks from the exposed wiring materials, as starting points, to result in a failure to accurately operate as a semiconductor element. Accordingly, it is desired to accurately control the etching rate for etching ruthenium, in order to achieve a precise microfabrication of ruthenium.

For example, Patent Document 1 discloses, as an etching liquid for wet etching of ruthenium, an etching liquid having a pH of more than 7 and containing an oxidizing agent, specifically, an etching liquid containing periodic acid as the oxidizing agent, boric acid as a buffer, and potassium hydroxide as a pH adjuster. It is disclosed therein that the etching liquid is capable of selectively etching ruthenium.

### RELATED ART DOCUMENT

### PATENT DOCUMENT

Patent Document 1: U.S. Patent Application Publication No. 2017/15585704

### SUMMARY OF THE INVENTION

### PROBLEMS TO BE SOLVED BY THE INVENTION

However, according to the investigation by the present inventors, it has been found out that there is room for improvement for the conventional etching liquid disclosed in Patent Document 1, in the following points.

For example, although Patent Document 1 discloses that the etching liquid described therein contains potassium hydroxide as a pH adjuster, the use of such an etching liquid may cause potassium to remain on the surface of a semiconductor wafer, after the etching of ruthenium. That is, the investigation by present inventors have revealed that potassium hydroxide contained in the etching liquid remains on the surface of wafer as potassium, to cause a decrease in the yield of the semiconductor element.

Further, it has been revealed that the ruthenium etching rate correlates with the pH of the etching liquid, in a semiconductor element formation process. In particular, it has been revealed that the pH of the etching liquid fluctuates even during etching processing, and affects the etching rate, and thus that it is necessary to precisely control the amount of addition of the pH adjuster.

In addition, it has been found out that the pH of the etching liquid can easily fluctuate due to the adsorption of carbon dioxide gas or chemical reactions during the pH adjustment or the reuse of the etching liquid, or during the storage and circulation of a drug solution. Although 10 mM of boric acid is added to the etching liquid disclosed in Patent Document 1, in order to reduce pH fluctuations, it has been revealed that boric acid in such a concentration fails to provide a sufficient buffering capacity, and that the fluctuations in pH causes the fluctuations in the etching rate.

Accordingly, an object of the present invention is to provide a treatment liquid which is capable of etching ruthenium present on a semiconductor wafer, at an etching rate with less fluctuations.

### MEANS FOR SOLVING THE PROBLEMS

The present inventors have made intensive studies to solve the above-mentioned problems. Further, the inventors have investigated the addition of a pH buffer to a treatment liquid containing hypochlorite ion and a tetraalkylammonium ion. As a result, the inventors have discovered that the addition of the pH buffer to the treatment liquid enables to reduce fluctuations in the pH of the treatment liquid, and to reduce fluctuations in the ruthenium etching rate, thereby completing the present invention.

Specifically, the present invention is:
(1) a treatment liquid for treating a semiconductor wafer in a semiconductor formation process; the treatment liquid comprising:
   (A) hypochlorite ion;
   (B) a pH buffer; and
   (C) a tetraalkylammonium ion represented by the following formula (1): 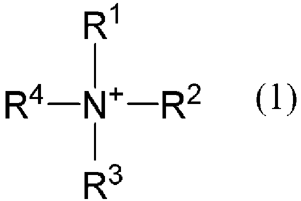
(wherein each of R¹, R², R³ and R⁴ is independently an alkyl group having carbon number from 1 to 20).

Further, the present invention can also be implemented in the following embodiments.

(2) The treatment liquid according to (1), wherein R¹, R², R³ and R⁴ in the formula (1) are the same alkyl group having carbon number from 1 to 3.

(3) The treatment liquid according to (1) or (2), wherein each of R¹, R², R³ and R⁴ in the formula (1) is a methyl group.

(4) The treatment liquid according to any one of (1) to (3), wherein the pH buffer (B) is at least one selected from the group consisting of: carbonic acid, boric acid, phosphoric acid, tris(hydroxymethyl)aminomethane(tris), ammonia, pyrophosphoric acid, p-phenolsulfonic acid, diethanolamine, ethanolamine, triethanolamine, 5,5-diethylbarbituric acid, glycine, glycylglycine, imidazole, N,N-bis(2-hydroxyethyl)-2-aminoethanesulfonic acid, 3-morpholinopropanesulfonic acid, N-tris(hydroxymethyl)methyl-2-aminoethanesulfonic acid, 2-[4-(2-hydroxyethyl)-1-piperazinyl]ethanesulfonic acid, 4-(2-hydroxyethyl)-1-piperazinepropanesulfonic acid, tricine, N,N-di(2-hydroxyethyl)glycine, 2-cyclohexylaminoethanesulfonic acid, hydroxyproline, phenol and ethylenediaminetetraacetic acid.

(5) The treatment liquid according to any one of (1) to (4), wherein a concentration of the hypochlorite ion (A) is from 0.05 to 20.0 mass%

(6) The treatment liquid according to any one of (1) to (5), wherein a concentration of the pH buffer (B) is from 0.0001 to 10 mass%.

(7) The treatment liquid according to any one of (1) to (6), wherein a pH at 25°C of the treatment liquid is 7 or more and less than 14.

(8) The treatment liquid according to any one of (1) to (7), wherein the pH buffer (B) is at least one selected from the group consisting of carbonic acid, boric acid and phosphoric acid.

(9) An etching method characterized by bringing the treatment liquid according to any one of (1) to (8) into contact with a semiconductor wafer.

(10) The etching method according to (9), wherein a metal contained in the semiconductor wafer is ruthenium, and wherein the ruthenium is etched.

(11) An inhibitor for inhibiting the generation of a ruthenium-containing gas, the inhibitor comprising the following (B) and (C):
(B) a pH buffer; and
(C) a tetraalkylammonium ion represented by the following formula (1): 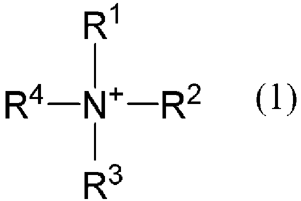
(wherein each of R¹, R², R³ and R⁴ is independently an alkyl group having carbon number from 1 to 20).

(12) The inhibitor for inhibiting the generation of a ruthenium-containing gas according to (11), further comprising (A) hypochlorite ion.

(13) The inhibitor for inhibiting the generation of a ruthenium-containing gas according to (11) or (12), wherein a concentration of the tetraalkylammonium ion (C) is from 0.0001 to 50 mass%.

(14) The inhibitor for inhibiting the generation of a ruthenium-containing gas according to any one of (11) to (13), wherein R¹, R², R³ and R⁴ in the formula (1) are the same alkyl group having carbon number from 1 to 3.

(15) A method for inhibiting the generation of a ruthenium-containing gas, the method comprising using the inhibitor for inhibiting the generation of a ruthenium-containing gas according to any one of (11) to (14).

(16) A treatment agent for treating a ruthenium-containing waste liquid, the treatment agent comprising the following (B) and (C):
(B) a pH buffer; and
(C) a tetraalkylammonium ion represented by the following formula (1): 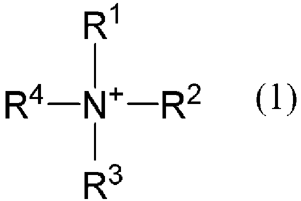
(wherein each of R¹, R², R³ and R⁴ is independently an alkyl group having carbon number from 1 to 20).

(17) The treatment agent for treating a ruthenium-containing waste liquid according to (16), further comprising (A) hypochlorite ion.

(18) The treatment agent for treating a ruthenium-containing waste liquid according to (16) or (17), wherein a concentration of the tetraalkylammonium ion (C) is from 0.0001 to 50 mass%.

(19) The treatment agent for treating a ruthenium-containing waste liquid according to any one of (16) to (18), wherein R¹, R², R³ and R⁴ in the formula (1) are the same alkyl group having carbon number from 1 to 3.

(20) A method for treating a ruthenium-containing waste liquid, the method comprising using the treatment agent for treating a ruthenium-containing waste liquid according to any one of (16) to (19).

The mechanism which allows the treatment liquid according to the present invention to accurately control the ruthenium etching rate is thought to be as follows. That is, even if the pH of the treatment liquid fluctuates, the neutralization reaction between the conjugate base of the pH buffer present in the treatment liquid and hydrogen ion enables to reduce fluctuations in the pH of the treatment liquid, making it possible to control the ruthenium etching rate at a constant rate.

### EFFECT OF THE INVENTION

According to the treatment liquid of the present invention, it is possible to provide a treatment liquid which achieves a high ruthenium etching rate, which is capable of reducing fluctuations in the etching rate due to fluctuations in the pH associated with the reaction in the etching of ruthenium or the adsorption of carbon dioxide gas, which enables to maintain a constant etching rate during use, and which allows for high-precision fabrication at a level of several nanometers.

### BRIEF DESCRIPTION OF THE DRAWINGS

FIG. 1 is a schematic cross-sectional view showing one example of a wiring formation step in which the treatment liquid according to the present invention can be suitably used.
FIG. 2 is a schematic cross-sectional view showing one example of the wiring formation step after being treated with the treatment liquid according to the present invention.
FIG. 3 is a schematic diagram showing one embodiment of the treatment liquid according to the present invention.

### MODE FOR CARRYING OUT THE INVENTION

### (Treatment liquid)

The treatment liquid according to the present invention is a treatment liquid which is capable of etching ruthenium present on a semiconductor wafer without causing damage on the semiconductor wafer, and which is capable of etching ruthenium at an etching rate with less fluctuations. Therefore, the treatment liquid according to the present invention is a treatment liquid which can be suitably used in the wiring formation step in a semiconductor production process.

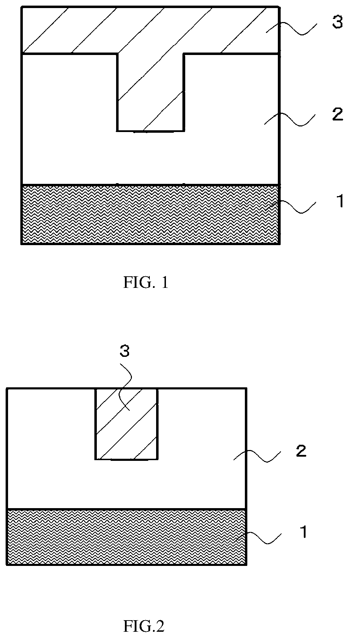

Ruthenium for which the treatment liquid according to the present invention is used, is mainly formed by CVD or a sputtering method which is used in the semiconductor element formation process. By etching ruthenium which has been formed as a wiring material, the wiring in the semiconductor is formed. Each of FIG. 1 and FIG. 2 shows one example of the wiring formation step. On a lower substrate 1, an interlayer insulating film 2 including a silicon oxide film, a low dielectric constant film and the like is formed, and a ruthenium film 3 is formed on the interlayer insulating film 2. By etching ruthenium as shown in FIG. 2, a wiring in which ruthenium is used as a wiring material is formed.

As described above, the treatment liquid according to the present invention can be suitably used for etching ruthenium. The treatment liquid described above is a treatment liquid containing (A) hypochlorite ion, (B) a pH buffer, and (C) a tetraalkylammonium ion. A description will be given below, step by step.

### (A) Hypochlorite Ion

The hypochlorite ion to be used in the present invention is obtained by dissolving chlorine gas in an alkaline solution to allow a neutralization reaction to occur. Further, it is also possible to dissolve hypochlorite in water to produce hypochlorous acid and hypochlorite ion.

In the treatment liquid according to the present invention, a concentration of the hypochlorite ion is preferably within the range of from 0.05 to 20 mass%. If the concentration of the hypochlorite ion is within the range described above, the etching of ruthenium can be performed. When the concentration of the hypochlorite ion is more than 20 mass%, the decomposition reaction of the hypochlorite ion occurs more easily, resulting in a failure to accurately control the etching rate. When the concentration of the hypochlorite ion is less than 0.05 mass%, on the other hand, the etching rate is significantly reduced. Accordingly, the concentration of the hypochlorite ion is preferably within the range of from 0.1 to 15 mass%, more preferably from 0.3 to 10 mass%, still more preferably from 0.5 to 7 mass%, and particularly preferably from 0.5 to 4 mass%.

In order to further reduce fluctuations in the etching rate of the treatment liquid, the concentration of the hypochlorite ion is preferably within the range of from 0.05 to 6 mass%. If the concentration of the hypochlorite ion is within the range described above, it is possible to reduce fluctuations in the etching rate, even after the addition of the pH buffer (B). Accordingly, considering the ruthenium etching rate and the stability of the hypochlorite ion, the concentration of the hypochlorite ion is more preferably within the range of from 0.1 to 6 mass%, still more preferably from 0.3 to 6 mass%, and particularly preferably from 0.5 to 4 mass%.

The concentration of the hypochlorite ion of the present invention can be determined by calculation at the time of producing the treatment liquid, or can be confirmed directly by analyzing the treatment liquid. The concentration of the hypochlorite ion described in the following Examples was determined by measuring the effective chlorine concentration of the treatment liquid. Specifically, potassium iodide and acetic acid were added to a solution containing hypochlorite ion, the effective chlorine concentration was calculated by redox titration of the liberated iodine with an aqueous thiosulfate solution, and the concentration of the hypochlorite ion was calculated from the thus calculated effective chlorine concentration, with reference to Notification of the Ministry of Health, Labor and Welfare No. 318 (Latest Revision, March 11, 2005).

### (B) pH Buffer

The pH buffer to be used in the present invention is a combination of a weak acid and a conjugate base, and is added to the treatment liquid for the purpose of reducing fluctuations in hydrogen ion concentration.

The pH buffer to be used is not particularly limited, and any pH buffer can be used as long as it is a substance having a pH buffering capacity, and is a combination of a weak acid and a conjugate base. Specific examples of cationic pH buffers which can be suitably used in the present invention include: carbonic acid, boric acid, phosphoric acid, tris(hydroxymethyl)aminomethane(tris), ammonia, pyrophosphoric acid, p-phenolsulfonic acid, diethanolamine, ethanolamine, triethanolamine, 5,5-diethylbarbituric acid, glycine, glycylglycine, imidazole, N,N-bis(2-hydroxyethyl)-2-aminoethanesulfonic acid, 3-morpholinopropanesulfonic acid, N-tris(hydroxymethyl)methyl-2-aminoethanesulfonic acid, 2-[4-(2-hydroxyethyl)-1-piperazinyl]ethanesulfonic acid, 4-(2-hydroxyethyl)-1-piperazinepropanesulfonic acid, tricine, N,N-di(2-hydroxyethyl)glycine, 2-cyclohexylaminoethanesulfonic acid, hydroxyproline, phenol and ethylenediaminetetraacetic acid.

In the present invention, only one kind of the pH buffer can be added, or two or more kinds of the pH buffers can be added in combination. The use of two or more kinds of the pH buffers in combination enables to reduce fluctuations in the pH, even if the pH of the treatment liquid becomes highly alkaline. In the present specification, the pH represents a value at 25°C.

In the present invention, it is preferred to use a pH buffer which contains at least boric acid, carbonic acid or phosphoric acid. In particular, it is expected that a desired pH buffering capacity can be obtained, when a pH of the treatment liquid is from 8.2 to 10.2 in the case of using boric acid, when a pH of the treatment liquid is from 9.3 to 11.3 in the case of using carbonic acid, and when a pH of the treatment liquid is from 11.4 to 13.4 in the case of using phosphoric acid. These pH buffers can be used singly, or as a mixture thereof. In the case of etching ruthenium, it is preferred to use a pH buffer which is not adsorbed on the surface of the ruthenium.

In the present invention, a concentration of the pH buffer to be contained in the treatment liquid is preferably from 0.0001 to 10%, more preferably from 0.001 to 8%, and still more preferably from 0.01 to 6%, with respect to the total mass of the treatment liquid. If the concentration of the pH buffer is within the range of from 0.1 to 6%, it is possible to reduce fluctuations in the pH of the treatment liquid, without affecting the etching rate.

If the content of the pH buffer in the treatment liquid according to the present invention is within the range of from 0.0001 to 10% with respect to the total mass of the treatment liquid, it is possible to stabilize the pH of the treatment liquid, and in addition, to reduce an increase in the viscosity of the treatment liquid; therefore, such a content is preferred. When the treatment liquid has a high viscosity, the use of the treatment liquid in a miniaturized wiring step, in particular, tends to be difficult, and thus, the content of the pH buffer is preferably within the range described above. Further, if the content of the pH buffer is within the range described above, the pH buffer can be sufficiently dissolved in the treatment liquid, and does not contaminate a subject to be etched due to the precipitation and the like of the pH buffer; therefore, such a content is preferred.

The mechanism which allows the treatment liquid according to the present invention to reduce fluctuations in the ruthenium etching rate, by the addition of the pH buffer thereto, is thought to be as follows. That is, even if the pH of the treatment liquid fluctuates, the neutralization reaction between the conjugate base of the pH buffer present in the treatment liquid and hydrogen ion enables to reduce fluctuations in the pH of the treatment liquid due to disturbances such as contact with the external air and the etching reaction. The above mechanism is thought to have enabled to reduce fluctuations in the ruthenium etching rate.

### (pH adjuster)

The pH adjuster to be used in the present invention is an acid or an alkali, which is different from the above-described pH buffer. For example, the pH adjuster is an acid, such as hydrochloric acid, sulfuric acid or nitric acid, or an alkali, such as an alkyl ammonium hydroxide such as tetramethylammonium hydroxide or choline.

When the treatment liquid contains the pH buffer, in the present invention, the range in which the pH is stabilized is determined by a combination of the pH adjuster and the pH buffer in the treatment liquid. For example, in cases where an aqueous solution of tetramethylammonium hydroxide is used as the pH adjuster, and boric acid is used as the pH buffer, it is possible to stabilize the pH of the treatment liquid within the range of from 8.2 to 10.2, thereby enabling to reduce fluctuations in the ruthenium etching rate. Further, since a compound containing an alkali metal, such as potassium hydroxide or sodium hydroxide, is not used as the pH adjuster, contamination by an alkali metal such as potassium or sodium will not be observed on the surface of a semiconductor substrate after etching, and thus the treatment liquid can be suitably used.

### (C) Tetraalkylammonium Ion

In the present invention, treatment liquid contains a tetraalkylammonium ion represented by the following formula (1), for the purpose of adjusting the pH of the treatment liquid. 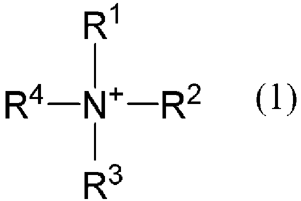 (In the formula (1), each of R¹, R², R³ and R⁴ is independently an alkyl group having carbon number from 1 to 20.)

R¹, R², R³ and R⁴ in the formula (1) are preferably the same alkyl group having carbon number from 1 to 3. Further, each of R¹, R², R³ and R⁴ in the formula (1) is preferably a methyl group or an ethyl group, and particularly preferably a methyl group.

In the treatment liquid according to an embodiment of the present invention, a concentration of the tetraalkylammonium ion preferably is within the range of from 0.1 to 30 mass%. By allowing the concentration of the tetraalkylammonium ion to satisfy the above-described range, the etching of ruthenium can be performed. As a result, a treatment liquid capable of performing a stable etching, and having an excellent long-term storage stability can be obtained. In order to provide the above-described effect more effectively, the concentration of the tetraalkylammonium ion is more preferably from 0.15 to 25 mass%, still more preferably from 0.3 to 21 mass%, and particularly preferably from 0.5 to 15 mass%. The concentration range, the preferred concentration range and the more preferred concentration range described above, can be applied to any of the specific examples of the tetraalkylammonium ion represented by the formula (1), exemplified by tetramethylammonium ion.

(Solvent)

In the treatment liquid according to the present invention, the balance excluding the components (A), (B) and (C), as well as the pH adjuster, and other additives to be described later, which are optional components, is a solvent. After adjusting the amounts of the components (A), (B) and (C), the pH adjuster, and other additives, a solvent is added to adjust the total amount to 100 mass%. The solvent can contain an anion. A possible anion to be contained can be chloride ion, hydroxide ion or the like.

In the present invention, the solvent is not particularly limited, and an organic solvent, water or the like can be used. In the case of using an organic solvent, it is preferred to use an organic solvent which can be present stably even in the presence of the hypochlorite ion contained in the treatment liquid, and examples thereof include acetonitrile and sulfolane. Further, in the case of using water, it is preferred to use water from which metal ions, organic impurities, particles and the like are removed by distillation, an ion exchange treatment, a filtering treatment, any of various types of adsorption treatments or the like. Particularly preferred is pure water or ultrapure water.

### (pH of Treatment liquid)

The treatment liquid according to the present invention contains the hypochlorite ion (A), the pH buffer (B), the tetraalkylammonium ion (C), other additives described below which are incorporated as necessary, and the solvent as the balance. Further, the treatment liquid contains the pH adjuster, as necessary. The pH of the treatment liquid can be easily adjusted to less than 14, by using a suitable concentration of the hypochlorite ion (A) (from 0.05 to 20 mass%), a suitable concentration of the pH buffer (B) (from 0.0001 to 10 mass%), and a suitable concentration of the tetraalkylammonium ion (C) (from 0.1 to 30 mass%), and by using the pH adjuster as necessary. If the pH of the treatment liquid according to the present invention is adjusted to less than 14 by adjusting the amount of the respective components, the pH of the treatment liquid does not fluctuate even when ruthenium is oxidized, dissolved and removed, thereby allowing for a stable removal of ruthenium. When the pH of the treatment liquid is 14 or more, ruthenium etching rate is significantly decreased. When the pH of the treatment liquid is less than 7, the decomposition reaction of the hypochlorite ion contained in the treatment liquid tends to occur more easily. Accordingly, considering achieving a high etching rate and a high precision control of the etching rate, the pH of the treatment liquid is preferably 7 or more and less than 14, more preferably 7.5 or more and less than 13.5, and still more preferably 9 or more and less than 13. In the case of using boric acid as the pH buffer, for example, a pH of less than 10 can also be exemplified as a preferred upper limit of the pH of the treatment liquid.

### (Other Additives)

In addition, the treatment liquid according to the present invention can optionally contain any of the additives which have been conventionally used in a treatment liquid for a semiconductor, as long as the object of the present invention is not impaired. For example, the treatment liquid can contain an acid, an alkali, a metal anticorrosive agent, a water-soluble organic solvent, a fluorine compound, an oxidizing agent, a reducing agent, a chelating agent, a surfactant, an antifoaming agent and/or the like, as the additive(s).

### (Method for Etching Ruthenium)

In the etching conditions under which the treatment liquid according to the present invention is used, the temperature is within the range of from 10 to 80°C, preferably from 20 to 70°C, and the temperature can be selected as appropriate depending on the etching conditions of the etching apparatus to be used.

The treatment liquid according to the present invention is used for a period of time within the range of from 0.1 to 120 minutes, preferably from 0.5 to 60 minutes, and the etching time can be selected as appropriate depending on the etching conditions and the semiconductor element to be used. An organic solvent such as an alcohol can be used as the rinsing liquid to be used after using the treatment liquid according to the present invention. However, rinsing with deionized water is sufficient.

As described above, the treatment liquid according to the present invention enables to perform the etching of a noble metal, particularly ruthenium, at an etching rate of 20 Å/min or higher, preferably 50 Å/min or higher, and to reduce the fluctuation ratio of ruthenium etching rate to 30% or less, by reducing pH fluctuations, even if the pH of the treatment liquid fluctuates due to disturbances, for example. As is evident from the above, the treatment liquid according to the present invention can be suitably used as a treatment liquid for etching ruthenium, in the case of using ruthenium in the semiconductor element formation process.

The treatment liquid according to the present invention also has a function to inhibit the generation of RuO₄ gas. The mechanism thereof is assumed as follows. That is, in the treatment liquid which is alkaline, anions (hereinafter, also referred to as RuO₄⁻ and the like) such as RuO₄⁻ and RuO₄²⁻ which are generated due to the dissolution of ruthenium interact electrostatically with onium ions contained in the treatment liquid, and some of the ions will be present stably as ion pairs in the treatment liquid. This inhibits the transformation of RuO₄⁻ and the like into RuO₄, as a result of which the generation of RuO₄ gas is inhibited. Further, since the generation of RuO₄ is inhibited, it is assumed that the formation of RuO₂ particles formed due to the reduction of RuO₄ is also inhibited.

Accordingly, in the treatment liquid according to the present invention, the effect of inhibiting the generation of RuO₄ gas due to the addition of the tetraalkylammonium ion represented by the formula (1) thereto, is not restricted by the types and the amounts of the oxidizing agent and other additives to be contained in the treatment liquid, the treatment method, the treatment conditions and the like. For example, although the oxidizing agent contained in the treatment liquid according to the present invention is the hypochlorite ion, the effect of inhibiting the generation of RuO₄ gas can be provided by the tetraalkylammonium ion represented by the formula (1) which is contained in the treatment liquid, regardless of the amount of the oxidizing agent. The method for treating a semiconductor wafer using the treatment liquid according to the present invention is not limited to wet etching, and the treatment liquid can also be suitably used as a treatment liquid for use in washing applications and residual removal applications. Further, if the treatment liquid according to the present invention is used in CMP polishing, it is possible to inhibit the generation of RuO₄ gas in a CMP polishing step, as well. The treatment of a wafer containing ruthenium using the treatment liquid according to the present invention can be single wafer treatment or immersion treatment. The temperature of the treatment liquid is not particularly limited, and the effect of inhibiting the generation of RuO₄ gas can be provided at any treatment temperature, by the tetraalkylammonium ion represented by the formula (1) which is contained in the treatment liquid.

### (Inhibitor for Inhibiting Generation of Ruthenium-containing Gas)

The "inhibitor for inhibiting the generation of a ruthenium-containing gas" (hereinafter, also simply referred to as "gas generation inhibitor") refers to a liquid which inhibits the generation of a ruthenium-containing gas by being added to a liquid for treating ruthenium, and which contains the above-described pH buffer and the tetraalkylammonium ion represented by formula (1).

The liquid for treating ruthenium can be any liquid containing a component which causes a chemical or physical change to ruthenium when brought into contact with ruthenium, and can be, for example, a solution containing an oxidizing agent. Examples of the oxidizing agent include hypochlorite ion as exemplified in the description above. All or a part of the ruthenium which has been treated with the liquid for treating ruthenium is dissolved, dispersed or precipitated in this treatment liquid, to cause the generation of RuO₄ (gas) and/or RuO₂ (particles).

Since the generation of RuO₄ (solution) and RuO₂ (particles) depends on the pH, it is preferred that the pH of the treatment liquid containing ruthenium do not fluctuate. Incorporation of the pH buffer into the inhibitor for inhibiting the generation of a ruthenium-containing gas enables to reduce fluctuations in the pH of the treatment liquid containing the gas generation inhibitor. It is possible to use any of the pH buffers as those exemplified above without any limitation, as the pH buffer.

In a liquid (also referred to as "treatment liquid containing the gas generation inhibitor") which contains the liquid for treating ruthenium and the inhibitor for inhibiting the generation of a ruthenium-containing gas according to the present invention, RuO₄⁻ and the like and the tetraalkylammonium ion present in this treatment liquid form ion pairs which dissolve in this treatment liquid, to inhibit the generation of RuO₄ (solution) and RuO₂ (particles) from RuO₄⁻ and the like. This is because the generation of RuO₄ (gas) from RuO₄ (solution) is significantly reduced, and at the same time, the formation of RuO₂ (particles) from RuO₄ (gas) is inhibited.

As described above, the treatment liquid according to the present invention is a treatment liquid capable of treating a semiconductor wafer containing ruthenium without causing the generation of RuO₄ gas, because the treatment liquid contains the tetraalkylammonium ion represented by the above-described formula (1) and the pH buffer. That is, the treatment liquid according to the present invention is the liquid for treating ruthenium, and at the same time, the inhibitor for inhibiting the generation of a ruthenium-containing gas. Therefore, the treatment liquid according to the present invention can also be used as the inhibitor for inhibiting the generation of a ruthenium-containing gas.

Regarding the conditions, such as the content of the tetraalkylammonium ion represented by the above-described formula (1), the types of other components and the contents thereof, and the pH, in the inhibitor for inhibiting the generation of a ruthenium-containing gas, the same conditions as those described in the description of the treatment liquid for a semiconductor wafer can be used.

However, the inhibitor for inhibiting the generation of a ruthenium-containing gas according to the present invention need not contain the hypochlorite ion (A) contained in the treatment liquid according to the present invention described above.

Other than the conditions described above, the content of the tetraalkylammonium represented by the formula (1) which is contained in the inhibitor for inhibiting the generation of a ruthenium-containing gas can be, for example, from 0.0001 to 50 mass%, and is more preferably from 0.01 to 35 mass%, still more preferably from 0.1 to 20 mass%. This concentration can be adjusted, as will be described later, such that the concentration of the liquid containing the above-described pH buffer and the tetraalkylammonium ion represented by the formula (1), in a target liquid for inhibiting the generation of a ruthenium-containing gas, namely, in a mixed liquid obtained by mixing with the liquid for treating ruthenium, is adjusted to a predetermined amount. Further, the same pH adjuster as one described above can be added, as appropriate, to the inhibitor for inhibiting the generation of a ruthenium-containing gas. The content of the pH adjuster can be adjusted, as will be described later, such that the pH of the mixed liquid obtained by mixing with the liquid for treating ruthenium is within a predetermined range. For example, the content of the pH adjuster in the inhibitor for inhibiting the generation of a ruthenium-containing gas is required to be an effective amount thereof, and can specifically be, for example, from 0.000001 to 10 mass%. Further, the inhibitor for inhibiting the generation of a ruthenium-containing gas preferably contains boric acid, carbonic acid or phosphoric acid, as the pH buffer. In particular, it is expected that a desired pH buffering capacity can be obtained, when the treatment liquid containing the gas generation inhibitor has a pH of from 8.2 to 10.2 in the case of using boric acid, when the treatment liquid containing the gas generation inhibitor has a pH of from 9.3 to 11.3 in the case of using carbonic acid, and when the treatment liquid containing the gas generation inhibitor has a pH of from 11.4 to 13.4 in the case of using phosphoric acid. These pH buffers can be used singly, or as a mixture thereof. Further, the concentration of each pH buffer in the treatment liquid containing the gas generation inhibitor is preferably from 0.0001 to 10%, more preferably from 0.001 to 8%, and still more preferably from 0.01 to 6%, with respect to the total mass of the treatment liquid containing the gas generation inhibitor. If the concentration of each pH buffer is within the range of from 0.1 to 6%, it is possible to reduce fluctuations in the pH of the treatment liquid, and to obtain a sufficient effect of inhibiting the generation of a ruthenium-containing gas, without affecting the etching rate.

### (Method for Inhibiting Generation of Ruthenium-containing Gas)

The method for inhibiting the generation of a ruthenium-containing gas according to the present invention is a method for inhibiting the generation of a ruthenium-containing gas, the method including the step of adding the inhibitor for inhibiting the generation of a ruthenium-containing gas described above, to the liquid for treating ruthenium. Specifically, for example, by adding the inhibitor for inhibiting the generation of a ruthenium-containing gas according to the present invention, to the liquid (the liquid for treating ruthenium) to be used in the steps of treating ruthenium, such as an etching step, a residual removal step, a washing step and a CMP step, in the semiconductor production process, it is possible to inhibit the generation of a ruthenium-containing gas. Further, the liquid containing the inhibitor for inhibiting the generation of a ruthenium-containing gas can also be used when washing the ruthenium adhered to the chamber inner walls, pipes and the like of the respective apparatuses used in the semiconductor production process, to inhibit the generation of a ruthenium-containing gas. For example, by adding the inhibitor for inhibiting the generation of a ruthenium-containing gas according to the present invention to a washing liquid which is used when removing the ruthenium adhered to the chamber and pipes, in the maintenance of an apparatus for forming ruthenium using physical vapor deposition (PVD) or chemical vapor deposition (CVD), it becomes possible to inhibit the generation of a ruthenium-containing gas which is generated during washing. According to this method, the generation a ruthenium-containing gas can be inhibited, by the mechanism described above in the description of the inhibitor for inhibiting the generation of a ruthenium-containing gas.

In the method for inhibiting the generation of a ruthenium-containing gas, it is preferred to adjust the concentration of the onium salt in the inhibitor for inhibiting the generation of a ruthenium-containing gas and the amount of addition thereof, such that the concentrations of the pH buffer and the tetraalkylammonium ion represented by the formula (1) in the mixed liquid of the inhibitor for inhibiting the generation of a ruthenium-containing gas and the liquid for treating ruthenium, are each within the range of from 0.0001 to 50 mass%. Further, in the case of adding the pH adjuster to the inhibitor for inhibiting the generation of a ruthenium-containing gas, the content of the pH adjuster in the inhibitor for inhibiting the generation of a ruthenium-containing gas, and the amount of addition of the inhibitor for inhibiting the generation of a ruthenium-containing gas can be adjusted as appropriate, such that a pH of the mixed liquid obtained by mixing with the liquid for treating ruthenium is, for example, from 7 to 14.

The amount of addition of the inhibitor for inhibiting the generation of a ruthenium-containing gas with respect to the amount of the liquid for treating ruthenium varies depending on the amount of ruthenium to be dissolved in the treatment liquid containing the gas generation inhibitor. The amount of addition of the inhibitor for inhibiting the generation of a ruthenium-containing gas is not particularly limited. For example, the amount of addition thereof is preferably from 10 to 500,000, more preferably from 100 to 100,000, and still more preferably from 1,000 to 50,000, in weight ratio, when the amount of ruthenium to be dissolved in the liquid for treating ruthenium is taken as 1.

### (Treatment Agent for Treating Ruthenium-containing Waste Liquid)

The treatment agent for treating a ruthenium-containing waste liquid according to the present invention is a treatment agent which inhibits the generation of a ruthenium-containing gas by being added to a ruthenium-containing waste liquid, and refers to a liquid containing the tetraalkylammonium ion represented by the formula (1) and the pH buffer. Accordingly, the treatment liquid which contains the tetraalkylammonium ion represented by the formula (1) can also be used as the treatment agent for treating a ruthenium-containing waste liquid, utilizing the effect thereof for inhibiting the generation of a ruthenium-containing gas.

The "ruthenium-containing waste liquid" as used herein refers to a solution which contains ruthenium, even in a small amount. The definition of "ruthenium" as used herein is not limited to ruthenium metal, and also encompasses those containing ruthenium element, such as, for example, Ru, RuO₄⁻, RuO₄²⁻, RuO₄ and RuO₂. The ruthenium-containing waste liquid can be, for example, a liquid obtained after performing the etching processing of a semiconductor wafer containing ruthenium using an etching liquid different from the treatment liquid according to the present invention, or a liquid obtained after performing the treating using the treatment liquid for a semiconductor wafer according to the present invention. Further, the ruthenium-containing waste liquid is not limited to one generated by the etching of a semiconductor wafer, and a ruthenium-containing liquid generated in the semiconductor production process or by chamber washing or the like, as described above in the description of the method for inhibiting the generation of a ruthenium-containing gas, is also one example of the ruthenium-containing waste liquid.

If the waste liquid contains ruthenium even in a trace amount, RuO₂ particles are formed via RuO₄ gas, to cause fouling of tanks and pipes, and to accelerate the deterioration of apparatuses due to the oxidative effect of the particles. Further, RuO₄ gas generated from the waste liquid shows a high toxicity for human body, even at a low concentration. Since the ruthenium-containing waste liquid have various adverse effects on apparatuses or on human body, as described above, it needs to be treated as soon as possible to inhibit the generation of RuO₄ gas.

By adding the treatment agent for treating a ruthenium-containing waste liquid according to the present invention to a ruthenium-containing waste liquid, it is possible to reduce a situation where the pH of the ruthenium-containing waste liquid fluctuates to cause an increase in the amount of RuO₄ gas or RuO₂ particles. For example, in cases where the ruthenium-containing waste liquid is alkaline, mixing of carbon dioxide causes a decrease in the pH of the ruthenium-containing waste liquid and an increase in the amount of RuO₄ gas or RuO₂ particles. However, the addition of the treatment agent for treating a ruthenium-containing waste liquid according to the present invention to the ruthenium-containing waste liquid reduces fluctuations in the pH, enabling to reduce the generated amount of RuO₄ gas and RuO₂ particles to a low level.

Regarding the conditions, such as the content of the tetraalkylammonium ion represented by the above-described formula (1), the types of other components and the contents thereof, and the pH, in the treatment agent for treating a ruthenium-containing waste liquid according to the present invention, the same conditions as those described in the description of the treatment liquid for a semiconductor wafer described above can be used.

However, the treatment agent for treating a ruthenium-containing waste liquid according to the present invention need not contain the hypochlorite ion (A) contained in the treatment liquid according to the present invention described above.

Other than these conditions, the content of the tetraalkylammonium represented by the formula (1) in the treatment agent for treating a ruthenium-containing waste liquid can be, for example, from 0.0001 to 50 mass%, and is more preferably from 0.001 to 35 mass%. This concentration can be adjusted, as will be described later, such that the concentration of the tetraalkylammonium represented by the formula (1), in a mixed liquid obtained by mixing with the ruthenium-containing waste liquid, is adjusted to a predetermined amount. Further, the same pH adjuster as one described above can be added, as appropriate, to the treatment agent for treating a ruthenium-containing waste liquid. The content of the pH adjuster can be adjusted, as will be described later, such that the pH of the mixed liquid obtained by mixing with the ruthenium-containing waste liquid is within a predetermined range. For example, the content of the pH adjuster in the treatment agent for treating a ruthenium-containing waste liquid is required to be an effective amount thereof, and can specifically be, for example, from 0.000001 to 10 mass%.

Further, the treatment agent for treating a ruthenium-containing waste liquid preferably contains boric acid, carbonic acid or phosphoric acid, as the pH buffer. In particular, it is expected that a desired pH buffering capacity can be obtained, when a pH of the treatment agent for treating a ruthenium-containing waste liquid is from 8.2 to 10.2 in the case of using boric acid, when a pH of the treatment agent for treating a ruthenium-containing waste liquid is from 9.3 to 11.3 in the case of using carbonic acid, and when a pH of the treatment agent for treating a ruthenium-containing waste liquid is from 11.4 to 13.4 in the case of using phosphoric acid. These pH buffers can be used singly, or as a mixture thereof. Further, the concentration of each pH buffer in the treatment agent for treating a ruthenium-containing waste liquid is preferably from 0.0001 to 10%, more preferably from 0.001 to 8%, and still more preferably from 0.01 to 6%, with respect to the total mass of the treatment agent for treating a ruthenium-containing waste liquid. If the concentration of each pH buffer is within the range of from 0.1 to 6%, it is possible to reduce fluctuations in the pH of the treatment agent for treating a ruthenium-containing waste liquid, and to obtain a sufficient effect of inhibiting the generation of a ruthenium-containing gas, without affecting the etching rate.

### (Method for Treating Ruthenium-containing Waste Liquid)

The method for treating a ruthenium-containing waste liquid according to the present invention is a method for treating a ruthenium-containing waste liquid, the method including the step of adding the treatment agent for treating a ruthenium-containing waste liquid described above, to the ruthenium-containing waste liquid to be described later. According to this method, the generation of a ruthenium-containing gas from the ruthenium-containing waste liquid can be inhibited, by the mechanism described above in the description of the inhibitor for inhibiting the generation of a ruthenium-containing gas. This not only facilitates the handleability of the ruthenium-containing waste liquid, but also enables to simplify exhaust equipment and removal equipment, and to reduce the cost required for the treatment of the ruthenium-containing gas. Further, it also reduces the risk of operators being exposed to a highly toxic ruthenium-containing gas, and greatly improves safety.

In the method for treating a ruthenium-containing waste liquid, it is preferred to adjust the concentrations of the pH buffer and the tetraalkylammonium ion represented by the formula (1) in the treatment agent for treating a ruthenium-containing waste liquid, and the amounts of addition thereof, for example, such that the concentrations of the tetraalkylammonium ion represented by the formula (1) and the pH buffer in a mixed liquid of the treatment agent for treating a ruthenium-containing waste liquid and the ruthenium-containing waste liquid, are each within the range of from 0.0001 to 50 mass%. Further, in the method for treating a ruthenium-containing waste liquid, the same pH adjuster as one described above can be added, as appropriate, to the treatment agent for treating a ruthenium-containing waste liquid. The content of the pH adjuster in the treatment agent for treating a ruthenium-containing waste liquid, and the amount of addition of the treatment agent for treating a ruthenium-containing waste liquid can be adjusted as appropriate, such that the mixed liquid obtained by mixing with the ruthenium-containing waste liquid has a pH of, for example, from 7 to 14.

The amount of addition of the treatment agent for treating a ruthenium-containing waste liquid with respect to the amount of the ruthenium-containing waste liquid varies depending on the amount of ruthenium in the ruthenium-containing waste liquid. The amount of addition of the treatment agent for treating a ruthenium-containing waste liquid is not particularly limited. For example, the amount of addition thereof is preferably from 10 to 500,000, more preferably from 100 to 100,000, and still more preferably from 1,000 to 50,000, in weight ratio, when the amount of ruthenium in the ruthenium-containing waste liquid is taken as 1.

### EXAMPLES

The present invention will be described in more specific detail with reference to Examples, but the present invention is not limited to these Examples.

### (Method for Measuring pH)

After preparing 30 mL of each of the treatment liquids of Examples 1 to 12 and Comparative Examples 1 to 6, the pH of each treatment liquid was measured using a tabletop pH meter (LAQUA F-73, manufactured by HORIBA, Ltd.). The measurement of the pH was carried out after the temperature of each treatment liquid was stabilized at 25°C.

(Method for Calculating Effective Chlorine Concentration and Hypochlorite Ion Concentration)

After preparing each of the treatment liquids of Examples 1 to 15 and Comparative Examples 1 to 6, 0.5 mL of each treatment liquid, 2 g of potassium iodide (special grade reagent; manufactured by FUJIFILM Wako Pure Chemical Corporation), 8 mL of 10% acetic acid and 10 mL of ultrapure water were added to a 100 mL Erlenmeyer flask, and the resultant is stirred until the solids were dissolved, to obtain a brown solution. The prepared brown solution was subjected to redox titration using a 0.02 M sodium thiosulfate solution (for volumetric analysis; manufactured by FUJIFILM Wako Pure Chemical Corporation) until the color of the solution turned from brown to very pale yellow. Subsequently, a starch solution was added to the resultant, to obtain a pale purple solution. The 0.02 M sodium thiosulfate solution was further added continuously to the resulting solution, and the effective chlorine concentration was calculated, taking the point at which the solution turned colorless and transparent, as the end point. Further, a hypochlorite ion concentration was calculated from the obtained effective chlorine concentration.

For example, if the effective chlorine concentration is 1%, the hypochlorite ion concentration is 0.73%.

### (Method for Measuring Alkylammonium Ion Concentration)

The alkylammonium ion concentration in each of the treatment liquids of Examples 1 to 15 and Comparative Examples 1 to 6 was determined by calculation from the pH and the hypochlorite ion concentration.

### (Method for Calculating Buffer Concentration)

The buffer concentration was determined by an analysis using an ion chromatography analyzer (DIONEX INTEGRION HPLC, manufactured by Thermo Fisher Scientific). KOH was used as an eluent, and allowed to flow at a flow rate of 1.2 mL/min. An anion analysis column for a hydroxide-based eluent (AS15, manufactured by Thermo Fisher Scientific) was used as the column, at a column temperature of 30°C. After removing the background noise by a suppressor, the carbonic acid concentration and the phosphoric acid concentration were quantified by an electrical conductivity detector.

### (pH Stability)

49.5 mL of each of the treatment liquids of Examples 1 to 15 and Comparative Examples 1 to 6 was prepared. Subsequently, 0.5 mL of 1 mass% hydrochloric acid was added to each of the treatment liquids of Examples 1 to 6, Example 9, Examples 11 to 14, and Comparative Examples 1 to 5, followed by stirring for 5 minutes. Thereafter, the measurement of the pH was carried out using a tabletop pH meter. To each of the treatment liquids of Examples 7, 8, 10 and 15, and Comparative Example 6, 0.5 mL of 5 mass% hydrochloric acid was added, followed by stirring for 5 minutes. Thereafter, the measurement of the pH was carried out using a tabletop pH meter.

### (Method for Calculating Ruthenium Etching Rate)

An oxide film was formed on a silicon wafer using a batch type thermal oxidation furnace, and a ruthenium film was formed on the oxide film using a sputtering method to a film thickness of 200 Å (±10%). The sheet resistance was measured using a four-probe resistance measuring instrument (Loresta-GP, manufactured by Mitsubishi Chemical Analytic Co., Ltd.), and the measured value was converted to the film thickness.

40 ml of each of the treatment liquids of Examples 1 to 15 and Comparative Examples 1 to 9 was prepared in a container made of a fluororesin and equipped with a lid (a 94.0 mL PFA container; manufactured by AS ONE Corporation). Each container was immersed in a water bath while stirring with a stirrer (CHPS-170DF; manufactured by AS ONE Corporation) at 800 rpm, and heated to the temperature shown in Table 1, Table 2 or Table 4. Each sample piece in a size of 10 × 20 mm was immersed in each of these treatment liquids, for 1 minute. Thereafter, the amount of change in the film thickness before and after the treating was divided by the immersion time, and the thus calculated value was taken as the etching rate.

### (Quantitative Analysis of RuO₄ Gas)

The generated amount of RuO₄ gas was measured using ICP-OES. 5 mL of each treatment liquid was weighed into an air-tight container, and one piece of Si wafer which is in a size of 10 × 20 mm and on which a ruthenium film having a film thickness of 1,200 Å had been formed, was immersed at each temperature shown in Table 4 for 60 minutes. The weight when all the ruthenium had been dissolved was taken as 0.000298 g. Thereafter, air was allowed to flow into the air-tight container, and the gas phase in the air-tight container was bubbled into a container containing an absorbent liquid (1 mol/L NaOH), so that RuO₄ gas generated during the immersion was trapped in the absorbent liquid. The amount of ruthenium in this absorbent liquid was measured by ICP-OES, to determine the amount of ruthenium in the RuO₄ gas generated. The fact that all the ruthenium on the Si wafer immersed in the treatment liquid had been dissolved was confirmed by measuring the sheet resistances before and after the immersion using the four-probe resistance measuring instrument (Loresta-GP, manufactured by Mitsubishi Chemical Analytic Co., Ltd.), and by converting the result to the film thickness.

### < Example 1 >

### (Preparation of Sample to be Etched)

A silicon wafer whose surface had been cleaned was prepared, and a thermal oxide film having a predetermined film thickness was formed thereon. On the thus obtained silicon wafer, a ruthenium film was formed by a sputtering method, to prepare a sample in which ruthenium is laminated on a silicon wafer having a film thickness of 200 Å.

### <Preparation of Quaternary Alkylammonium Hypochlorite Solution >

To a 2 L three-neck flask made of glass (manufactured by Cosmos Vid), 253 g of a 25 mass% aqueous solution of tetramethylammonium hydroxide, having a CO₂ content of 2 ppm, and 747 g of ion exchanged water were introduced, and mixed to obtain a 6.3 mass% aqueous solution of tetramethylammonium hydroxide, having a CO₂ content of 0.5 ppm. At this time, the solution had a pH of 13.8.

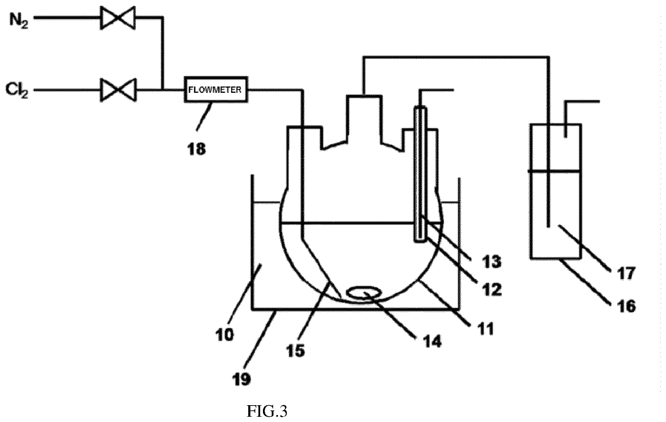

Thereafter, as shown in FIG. 3, a rotor (total length: 30 mm × diameter: 8 mm; manufactured by AS ONE Corporation) was placed in the three-neck flask, and a thermometer protection tube (bottom-sealed type; manufactured by Cosmos Vid) and a thermometer were placed into one opening of the flask. Through another opening of the flask, the tip of a PFA tube (F-8011-02; manufactured by Flon Industry Co., Ltd.) was introduced and immersed at the bottom in the solution. This PFA tube was connected to a chlorine gas cylinder and a nitrogen gas cylinder, and configured such that the switching between the chlorine gas and the nitrogen gas can be performed arbitrarily. The remaining one opening was connected to a gas-washing bottle (gas-washing bottle, model number: 2450/500; manufactured by AS ONE Corporation) filled with a 5 mass% aqueous sodium hydroxide solution. Subsequently, a nitrogen gas having a carbon dioxide concentration of less than 1 ppm was allowed to flow through the PFA tube, at 0.289 Pa·m³ /sec (when converted to 0°C) for 20 minutes, to push out carbon dioxide of the gas phase portion. At this time, the gas phase portion had a carbon dioxide concentration of 1 ppm or less.

Thereafter, a magnet stirrer (C-MAG HS10; manufactured by AS ONE Corporation) was installed under the three-neck flask to rotate and stir at 300 rpm, and a chlorine gas (specification purity: 99.4%; manufactured by Fujiox Co., ltd.) was supplied at 0.064 Pa·m³ /sec (when converted to 0°C) for 180 minutes, while cooling the outer peripheral portion of the three-neck flask with ice water, to obtain a tetramethylammonium hypochlorite solution. At this time, the liquid temperature during the reaction was 11°C.

The resulting solution was placed into a glove bag, in the state contained in the three-neck flask made of glass, and so as not to come into contact with air. After the carbon dioxide concentration in the glove bag decreased to 1 ppm or less, the solution was transferred to a 1 L PFA container. 22.3g of boric acid (special grade reagent; manufactured by FUJIFILM Wako Pure Chemical Corporation) was dissolved in 1 L of the resulting solution, to obtain a treatment liquid having the composition shown in Table 1.

### < Evaluation >

The pH, the effective chlorine concentration and the hypochlorite ion concentration of the resulting treatment liquid were evaluated, and further, the alkylammonium ion concentration, the ruthenium etching rate, the pH after the addition of hydrochloric acid, the ruthenium etching rate after the addition of the acid, and the etching fluctuation ratio before and after the addition of hydrochloric acid were evaluated. The results are shown in Table 2. It is noted that the fluctuation range of the etching rate was evaluated, by adding hydrochloric acid to the treatment liquid so that the pH of the treatment liquid is forced to shift to the acidic side.

### < Examples 2 to 4, Example 9, Examples 11 and 12, Comparative Examples 1 and 2, and Comparative Examples 5 and 6 >

In Example 2 to 4, Example 9, Examples 11 and 12, Comparative Examples 1 and 2 as well as Comparative Examples 5 and 6, treatment liquids were prepared and evaluated in the same manner as in Example 1, except that the compositions of the hypochlorite ion (A), the pH buffer (B) and the tetramethylammonium ion (C), and the values of pH were adjusted as shown in Table 1.

### < Example 5 >

### < Preparation of Carbonic Acid Buffer >

A PFA beaker containing 500 g of a 25 mass% aqueous solution of tetramethylammonium hydroxide was placed in a glove bag, and the carbon dioxide concentration in the glove bag was adjusted to 1 ppm. Thereafter, 30.7 L (when converted to 0°C) of a high-purity carbon dioxide gas (specification purity: 99.99% or more; manufactured by Showa Denko Gas Products Co., Ltd.) was supplied into the glove bag, and the bag was sealed for 24 hours, to obtain a carbonic acid buffer. The buffer concentration was calculated using an ion chromatography analyzer, in accordance with the method described above.

### < Preparation of Quaternary Alkylammonium Hypochlorite Solution >

To a 2 L three-neck flask made of glass (manufactured by Cosmos Vid), 185 g of a 25 mass% aqueous solution of tetramethylammonium hydroxide, having a CO₂ content of 2 ppm, and 415 g of ion exchanged water were introduced, and mixed to obtain a 7.7 mass% aqueous solution of tetramethylammonium hydroxide, having a CO₂ content of 0.5 ppm. At this time, a pH of the solution was 13.9.

Thereafter, as shown in FIG. 3, a rotor (total length: 30 mm × diameter: 8 mm; manufactured by AS ONE Corporation) was placed in the three-neck flask, and a thermometer protection tube (bottom-sealed type; manufactured by Cosmos Vid) and a thermometer were placed into one opening of the flask. Through another opening of the flask, the tip of a PFA tube (F-8011-02; manufactured by Flon Industry Co., Ltd.) was introduced and immersed at the bottom in the solution. This PFA tube was connected to a chlorine gas cylinder and a nitrogen gas cylinder, and configured such that the switching between the chlorine gas and the nitrogen gas can be performed arbitrarily. The remaining one opening was connected to a gas-washing bottle (gas-washing bottle, model number: 2450/500; manufactured by AS ONE Corporation) filled with a 5 mass% aqueous sodium hydroxide solution. Subsequently, a nitrogen gas having a carbon dioxide concentration of less than 1 ppm was allowed to flow through the PFA tube, at 0.289 Pa·m³ /sec (when converted to 0°C) for 20 minutes, to push out carbon dioxide of the gas phase portion. At this time, the gas phase portion had a carbon dioxide concentration of 1 ppm or less.

Thereafter, a magnet stirrer (C-MAG HS10; manufactured by AS ONE Corporation) was installed under the three-neck flask to rotate and stir at 300 rpm, and a chlorine gas (specification purity: 99.4%; manufactured by Fujiox Co., ltd.) was supplied at 0.053 Pa·m³ /sec (when converted to 0°C) for 180 minutes, while cooling the outer peripheral portion of the three-neck flask with ice water, to obtain a tetramethylammonium hypochlorite solution. At this time, the liquid temperature during the reaction was 11°C.

The resulting solution was placed into a glove bag, in the state contained in the three-neck flask made of glass, and so as not to come into contact with air. After the carbon dioxide concentration in the glove bag decreased to 1 ppm or less, the solution was transferred to a 1 L PFA container. 300 g of the buffer was dissolved in 600 g of the resulting solution, to obtain a treatment liquid having the composition shown in Table 1, and the evaluation thereof was carried out.

### <Example 6 >

In Example 6, a treatment liquid was prepared and evaluated in the same manner as in Example 5, except that the composition of the hypochlorite ion (A), the pH buffer (B) and the tetramethylammonium ion (C), and the value of pH were adjusted as shown in Table 1.

### < Example 7 >

### < Preparation of Phosphoric Acid Buffer >

500 g of a 25 mass% aqueous solution of tetramethylammonium hydroxide was introduced into a PFA container, and 60.3 g of phosphoric acid (specification purity: 85%; manufactured by FUJIFILM Wako Pure Chemical Corporation) was added thereto while cooling with ice water, to obtain a phosphoric acid buffer. The buffer concentration was calculated using an ion chromatography analyzer, in accordance with the method described above.

### < Preparation of Quaternary Alkylammonium Hypochlorite Solution >

To a 2 L three-neck flask made of glass (manufactured by Cosmos Vid), 379 g of a 25 mass% aqueous solution of tetramethylammonium hydroxide, having a CO₂ content of 2 ppm, and 221 g of ion exchanged water were introduced, and mixed to obtain a 15.8 mass% aqueous solution of tetramethylammonium hydroxide, having a CO₂ content of 0.5 ppm. At this time, the solution had a pH of 14.2.

Thereafter, as shown in FIG. 3, a rotor (total length: 30 mm × diameter: 8 mm; manufactured by AS ONE Corporation) was placed in the three-neck flask, and a thermometer protection tube (bottom-sealed type; manufactured by Cosmos Vid) and a thermometer were placed into one opening of the flask. Through another opening of the flask, the tip of a PFA tube (F-8011-02; manufactured by Flon Industry Co., Ltd.) was introduced and immersed at the bottom in the solution. This PFA tube was connected to a chlorine gas cylinder and a nitrogen gas cylinder, and configured such that the switching between the chlorine gas and the nitrogen gas can be performed arbitrarily. The remaining one opening was connected to a gas-washing bottle (gas-washing bottle, model number: 2450/500; manufactured by AS ONE Corporation) filled with a 5 mass% aqueous sodium hydroxide solution. Subsequently, a nitrogen gas having a carbon dioxide concentration of less than 1 ppm was allowed to flow through the PFA tube, at 0.289 Pa·m³ /sec (when converted to 0°C) for 20 minutes, to push out carbon dioxide of the gas phase portion. At this time, the gas phase portion had a carbon dioxide concentration of 1 ppm or less.

Thereafter, a magnet stirrer (C-MAG HS10; manufactured by AS ONE Corporation) was installed under the three-neck flask to rotate and stir at 300 rpm, and a chlorine gas (specification purity: 99.4%; manufactured by Fujiox Co., ltd.) was supplied at 0.107 Pa·m³ /sec (when converted to 0°C) for 180 minutes, while cooling the outer peripheral portion of the three-neck flask with ice water, to obtain a tetramethylammonium hypochlorite solution. At this time, the liquid temperature during the reaction was 11°C.

The resulting solution was placed into a glove bag, in the state contained in the three-neck flask made of glass, and so as not to come into contact with air. After the carbon dioxide concentration in the glove bag decreased to 1 ppm or less, the solution was transferred to a 1 L PFA container. 300 g of the buffer was dissolved in 600 g of the resulting solution, to obtain a treatment liquid having the composition shown in Table 1.

### < Example 8 and Example 10 >

In Example 8 and Example 10, treatment liquids were prepared and evaluated in the same manner as in Example 7, except that the compositions of the hypochlorite ion (A), the pH buffer (B) and the tetramethylammonium ion (C), and the values of pH were adjusted as shown in Table 1.

### < Evaluation >

The pH, the effective chlorine concentration and the hypochlorite ion concentration of each resulting treatment liquid were evaluated, and further, the tetraalkylammonium ion concentration, the ruthenium etching rate, the pH after the addition of hydrochloric acid, the ruthenium etching rate after the addition of the acid, and the etching fluctuation ratio before and after the addition of hydrochloric acid were evaluated. The results are shown in Table 2. It is noted that the fluctuation range of the etching rate was evaluated, by adding hydrochloric acid to the treatment liquid so that the pH of the treatment liquid is forced to shift to the acidic side.

### < Comparative Example 3 >

2.5 g of orthoperiodic acid (Wako Special grade; manufactured by FUJIFILM Wako Pure Chemical Corporation) and 967.5 g of ion exchanged water were mixed to obtain a 0.25 mass% aqueous orthoperiodic acid solution. To the resulting solution, 30 g of a 25 mass% aqueous solution of tetramethylammonium hydroxide was mixed, to obtain a treatment liquid having the composition shown in Table 2. Thereafter, the evaluation was carried out in the same manner as in Example 1.

### < Comparative Example 4 >

0.6 g of boric acid (special grade reagent; manufactured by FUJIFILM Wako Pure Chemical Corporation) was dissolved in the solution obtained in the Comparative Example 3 described above, and an aqueous solution of tetramethylammonium hydroxide was mixed thereto so as to achieve a pH of 9.23, to obtain a treatment liquid having the composition shown in Table 2. Thereafter, the evaluation was carried out in the same manner as in Example 1.

The compositions of the treatment liquids prepared in the Examples and Comparative Examples described above are shown in Table 1 and Table 2, and the obtained results are shown in Table 3.

**[Table 1]**

| | (A) Hypochlorite ion (mass%) (HClO and ClO⁻) | Effective chlorine concentration (mass%) | (B) pH buffer | (B) pH buffer (mass%) | (C) Tetraalkylammonium ion (mass%) (TMA+) | Water | Treatment temperature (°C) |
|---|---|---|---|---|---|---|---|
| Example 1 | 1.5 | 2.00 | Boric acid | 2.23 | 5.02 | 91.30 | 23 |
| Example 2 | 1.5 | 2.00 | Boric acid | 0.49 | 5.10 | 92.96 | 23 |
| Example 3 | 2.2 | 3.00 | Boric acid | 1.92 | 7.18 | 88.75 | 23 |
| Example 4 | 1.5 | 2.00 | Boric acid | 0.10 | 5.13 | 93.32 | 23 |
| Example 5 | 1.5 | 2.00 | Carbonic acid | 5.49 | 11.17 | 81.89 | 23 |
| Example 6 | 1.5 | 2.00 | Carbonic acid | 0.10 | 11.17 | 87.28 | 23 |
| Example 7 | 2.9 | 4.00 | Phosphoric acid | 3.31 | 15.30 | 78.49 | 80 |
| Example 8 | 2.9 | 4.00 | Phosphoric acid | 0.10 | 15.30 | 81.70 | 80 |
| Example 9 | 0.1 | 0.07 | Boric acid | 2.23 | 0.18 | 97.54 | 60 |
| Example 10 | 5.8 | 8.00 | Phosphoric acid | 3.31 | 17.03 | 73.86 | 80 |
| Example 11 | 0.5 | 0.69 | Boric acid | 2.23 | 1.44 | 95.83 | 45 |
| Example 12 | 0.2 | 0.28 | Boric acid | 2.23 | 0.59 | 96.98 | 45 |
| Comparative Example 1 | 1.5 | 2.00 | - | - | 4.10 | 94.45 | 23 |
| Comparative Example 2 | 1.5 | 2.00 | - | - | 4.13 | 94.42 | 23 |
| Comparative Example 5 | 1.5 | 2.00 | - | - | 4.19 | 94.36 | 23 |
| Comparative Example 6 | 2.9 | 4.00 | - | - | 8.70 | 88.40 | 80 |

| | | | | | | | |
|---|---|---|---|---|---|---|---|
| * In Table 1, water contains chloride ion. | | | | | | | |

**[Table 2]**

| | Orthoperiodic acid (mass%) | (B) pH buffer | (B) pH buffer (mass%) | (C) Tetraalkylammonium ion (mass%) (TMA+) | Treatment temperature (°C) |
|---|---|---|---|---|---|
| Comparative Example 3 | 0.25 | - | - | 2.50 | 45 |
| Comparative Example 4 | 0.25 | Boric acid | 0.06 | 2.57 | 45 |

**[Table 3]**

| | Initial pH (25°C) | Initial Ru etching rate (Å/min) | pH after the addition of HCl (25°C) | Ru etching rate after the addition of HCl (Å/min) | Fluctuation ratio of etching rate |
|---|---|---|---|---|---|
| Example 1 | 9.23 | 85 | 9.23 | 85 | < 1% |
| Example 2 | 9.23 | 113 | 9.18 | 123 | 9% |
| Example 3 | 9.48 | 90 | 9.48 | 90 | < 1% |
| Example 4 | 9.23 | 137 | 9.16 | 160 | 17% |
| Example 5 | 10.57 | 37 | 10.55 | 38 | 3% |
| Example 6 | 10.57 | 40 | 10.50 | 43 | 8% |
| Example 7 | 12.64 | 20 | 12.62 | 21 | 3% |
| Example 8 | 12.64 | 21 | 12.59 | 23 | 10% |
| Example 9 | 9.23 | 20 | 9.23 | 20 | < 1% |
| Example 10 | 12.63 | 38 | 12.61 | 39 | 3% |
| Example 11 | 9.25 | 119 | 9.25 | 119 | < 1% |
| Example 12 | 9.23 | 61 | 9.23 | 61 | < 1% |
| Comparative Example 1 | 9.23 | 142 | 9.08 | 210 | 48% |
| Comparative Example 2 | 9.48 | 29 | 9.40 | 39 | 34% |
| Comparative Example 3 | 9.23 | 8 | 9.08 | 12 | 50% |
| Comparative Example 4 | 9.23 | 5 | 9.12 | 7 | 40% |
| Comparative Example 5 | 10.57 | 40 | 9.71 | 110 | 175% |
| Comparative Example 6 | 12.64 | 21 | 12.38 | 34 | 62% |

### <Example 13 >

In Example 13, a treatment liquid was prepared and evaluated in the same manner as in Example 1, except that the composition of the hypochlorite ion (A), the pH buffer (B) and the tetraalkylammonium ions (C) was adjusted as shown in Table 4.

### <Example 14 >

In Example 14, a treatment liquid was prepared and evaluated in the same manner as in Example 5, except that the composition of the hypochlorite ion (A), the pH buffer (B) and the tetraalkylammonium ions (C) was adjusted as shown in Table 4.

### <Example 15 >

In Example 15, a treatment liquid was prepared and evaluated in the same manner as in Example 7, except that the composition of the hypochlorite ion (A), the pH buffer (B) and the tetraalkylammonium ions (C) was adjusted as shown in Table 4.

### < Evaluation >

The pH, the effective chlorine concentration and the hypochlorite ion concentration of each resulting treatment liquid were evaluated, and further, the tetraalkylammonium ion concentration, the ruthenium etching rate, the pH after the addition of hydrochloric acid, the ruthenium etching rate after the addition of the acid, the etching fluctuation ratio before and after the addition of hydrochloric acid, and the quantitative analysis of RuO₄ gas were evaluated. The results are shown in Table 5. It is noted that the fluctuation range of the etching rate was evaluated, by adding hydrochloric acid to the treatment liquid so that the pH of the treatment liquid is forced to shift to the acidic side. It can be seen from the results shown in Table 5 that it was possible to reduce the fluctuation ratio of the etching rate to a low level, even in cases where the treatment liquid contains two kinds of tetraalkylammonium ions represented by the formula (1).

**[Table 4]**

| | (A) Hypochlorite ion (mass%) (HClO and ClO) | Effective chlorine concentration (mass%) | (B) pH buffer | (B) pH buffer (mass%) | (C) Tetraalkylammonium ion (mass%) | (C) Tetraalkylammonium ion (mass%) | Water | Treatment temperature (°C) |
|---|---|---|---|---|---|---|---|---|
| Example 13 | 1.45 | 2.00 | Boric acid | 2.23 | Tetramethylammonium hydroxide (5.02) | Tetrapropylammonium hydroxide (8.8) | 82.50 | 23 |
| Example 14 | 1.45 | 2.00 | Carbonic acid | 5.49 | Tetramethylammonium hydroxide (11.17) | Tetrapropylammonium hydroxide (8.8) | 73.09 | 23 |
| Example 15 | 2.90 | 4.00 | Phosphoric acid | 3.31 | Tetramethylammonium hydroxide (15.3) | Tetrapropylammonium hydroxide (8.8) | 69.69 | 80 |

| | | | | | | | | |
|---|---|---|---|---|---|---|---|---|
| *In Table 4, water contains chloride ion. | | | | | | | | |

**[Table 5]**

| | Initial pH (25°C) | Initial Ru etching (Å/min) | pH after the addition of HCl (25°C) | Ru etching after the addition of HCl (Å/min) | Fluctuation ratio of etching rate | Ru amount in RuO₄ gas µg/cm²) |
|---|---|---|---|---|---|---|
| Example 13 | 9.23 | 79 | 9.23 | 80 | < 1% | 26 |
| Example 14 | 10.57 | 32 | 10.55 | 34 | 6% | 18 |
| Example 15 | 12.64 | 20 | 12.62 | 20 | 1% | 4 |

### DESCRIPTION OF SYMBOLS

- 1: substrate
- 2: interlayer insulating film
- 3: ruthenium
- 11: three-neck flask
- 12: thermometer protection tube
- 13: thermocouple
- 14: rotor
- 15: PFA tube
- 16: gas-washing bottle
- 17: 5 mass% aqueous sodium hydroxide solution
- 18: flowmeter
- 19: water bath
- 10: ice water

## Claims

1. A treatment liquid for treating a semiconductor wafer in a semiconductor formation process; the treatment liquid comprising:
(A) hypochlorite ion;
(B) a pH buffer; and
(C) a tetraalkylammonium ion represented by the following formula (1): 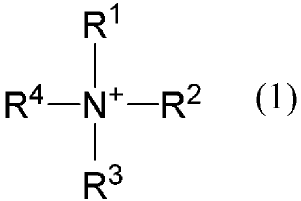
(wherein each of R¹, R², R³ and R⁴ is independently an alkyl group having carbon number from 1 to 20).

2. The treatment liquid according to claim 1, wherein R¹, R², R³ and R⁴ in the formula (1) are the same alkyl group having carbon number from 1 to 3.

3. The treatment liquid according to claim 1 or 2, wherein each of R¹, R², R³ and R⁴ in the formula (1) is a methyl group.

4. The treatment liquid according to any one of claims 1 to 3, wherein the pH buffer (B) is at least one selected from the group consisting of: carbonic acid, boric acid, phosphoric acid, tris(hydroxymethyl)aminomethane(tris), ammonia, pyrophosphoric acid, p-phenolsulfonic acid, diethanolamine, ethanolamine, triethanolamine, 5,5-diethylbarbituric acid, glycine, glycylglycine, imidazole, N,N-bis(2-hydroxyethyl)-2-aminoethanesulfonic acid, 3-morpholinopropanesulfonic acid, N-tris(hydroxymethyl)methyl-2-aminoethanesulfonic acid, 2-[4-(2-hydroxyethyl)-1-piperazinyl]ethanesulfonic acid, 4-(2-hydroxyethyl)-1-piperazinepropanesulfonic acid, tricine, N,N-di(2-hydroxyethyl)glycine, 2-cyclohexylaminoethanesulfonic acid, hydroxyproline, phenol and ethylenediaminetetraacetic acid.

5. The treatment liquid according to any one of claims 1 to 4, wherein a concentration of the hypochlorite ion (A) is from 0.05 to 20.0 mass%.

6. The treatment liquid according to any one of claims 1 to 5, wherein the pH buffer (B) has a concentration of from 0.0001 to 10 mass%.

7. The treatment liquid according to any one of claims 1 to 6, wherein a pH at 25°C of the treatment liquid is 7 or more and less than 14.

8. The treatment liquid according to any one of claims 1 to 7, wherein the pH buffer (B) is at least one selected from the group consisting of carbonic acid, boric acid and phosphoric acid.

9. An etching method comprising the step of bringing the treatment liquid according to any one of claims 1 to 8 into contact with a semiconductor wafer.

10. The etching method according to claim 9, wherein a metal contained in the semiconductor wafer is ruthenium, and wherein the ruthenium is etched.

11. An inhibitor for inhibiting the generation of a ruthenium-containing gas, the inhibitor comprising the following (B) and (C):
(B) a pH buffer; and
(C) a tetraalkylammonium ion represented by the following formula (1): 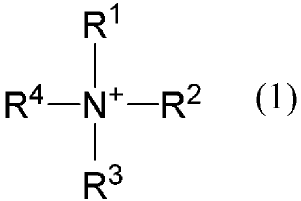
(wherein each of R¹, R², R³ and R⁴ is independently an alkyl group having carbon number from 1 to 20).

12. The inhibitor for inhibiting the generation of a ruthenium-containing gas according to claim 11, further comprising (A) hypochlorite ion.

13. The inhibitor for inhibiting the generation of a ruthenium-containing gas according to claim 11 or 12, wherein a concentration of the tetraalkylammonium ion (C) is from 0.0001 to 50 mass%.

14. The inhibitor for inhibiting the generation of a ruthenium-containing gas according to any one of claims 11 to 13, wherein R¹, R², R³ and R⁴ in the formula (1) are the same alkyl group having carbon number from 1 to 3.

15. A method for inhibiting the generation of a ruthenium-containing gas, the method comprising using the inhibitor for inhibiting the generation of a ruthenium-containing gas according to any one of claims 11 to 14.

16. A treatment agent for treating a ruthenium-containing waste liquid, the treatment agent comprising the following (B) and (C):
(B) a pH buffer; and
(C) a tetraalkylammonium ion represented by the following formula (1): 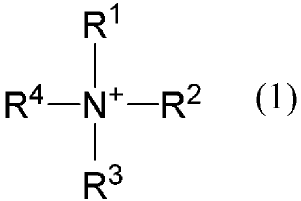
(wherein each of R¹, R², R³ and R⁴ is independently an alkyl group having carbon number from 1 to 20).

17. The treatment agent for treating a ruthenium-containing waste liquid according to claim 16, further comprising (A) hypochlorite ion.

18. The treatment agent for treating a ruthenium-containing waste liquid according to claim 16 or 17, wherein a concentration of the tetraalkylammonium ion (C) is from 0.0001 to 50 mass %.

19. The treatment agent for treating a ruthenium-containing waste liquid according to any one of claims 16 to 18, wherein R¹, R², R³ and R⁴ in the formula (1) are the same alkyl group having carbon number from 1 to 3.

20. A method for treating a ruthenium-containing waste liquid, the method comprising using the treatment agent for treating a ruthenium-containing waste liquid according to any one of claims 16 to 19.
